# EUROPEAN PATENT SPECIFICATION

(11) **EP 4 549 971 B1**
(45) Date of publication and mention of the grant of the patent: **30.09.2026**
(21) Application number: 23872785.3
(22) Date of filing: 09.08.2023
(51) Int. Cl.: G01R 31/392, G01R 31/371, G01R 31/382, G01R 31/396, H01M 10/48, H01M 10/052

(54) **BATTERY MANAGEMENT APPARATUS AND OPERATING METHOD THEREOF**
BATTERIEVERWALTUNGSVORRICHTUNG UND BETRIEBSVERFAHREN DAFÜR
APPAREIL DE GESTION DE BATTERIE ET SON PROCÉDÉ DE FONCTIONNEMENT

(30) Priority: 27.09.2022 KR 20220122898
(43) Date of publication of application: 07.05.2025
(73) Proprietor: LG Energy Solution, Ltd., Seoul 07335 (KR)
(72) Inventor: LEE, Sung Gun, Daejeon 34122 (KR)
(74) Representative: Plasseraud IP
(86) International application number: PCT/KR2023/011775
(87) International publication number: WO 2024/071662

(56) References cited:
- CN-A- 107 769 330
- KR-A- 20080 010 698
- KR-A- 20100 089 768
- KR-A- 20120 059 247
- KR-A- 20190 000 142
- KR-B1- 101 610 925

## Description

### [TECHNICAL FIELD]

### CROSS-REFERENCE TO RELATED APPLICATION

### TECHNICAL FIELD

Embodiments disclosed herein relate to a battery management apparatus and an operating method thereof.

### [BACKGROUND ART]

Recently, research and development of secondary batteries have been actively performed. Secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

To further increase the usability and portability of the lithium-ion battery, a battery swapping service has been provided. However, when some of the batteries in a battery swapping station catch fire, chain ignition may occur to nearby batteries, causing all batteries in the battery swapping station to burn out.

A discharge rate of the igniting battery may be raised to prevent the chain ignition of the battery swapping station, but the discharge rate of the battery may be determined and fixed by a resistance value of a discharge resistor connected to the battery, such that the discharge resistor needs to be changed to adjust the discharge rate. Document CN107769330A discloses to use resistors as inrush current limiting elements which are temporarily placed in series with the load to limit the current during a switching event. The switches are arranged to either connect a battery to the load via its series resistor, or to bypass said resistor.

### [DISCLOSURE]

### [TECHNICAL PROBLEM]

Embodiments disclosed herein provide a battery management apparatus and an operating method thereof in which a discharge rate and/or heating of a battery may be controlled using a plurality of resistors connected to one another in parallel.

Technical problems of the embodiments disclosed herein are not limited to the above-described technical problems, and other unmentioned technical problems would be clearly understood by one of ordinary skill in the art from the following description.

### [TECHNICAL SOLUTION]

The present invention provides a battery management apparatus according to claim 1.

In an embodiment, the battery management apparatus may further include a communication unit configured to receive an abnormality signal of the plurality of batteries from a battery management system (BMS) for each of the plurality of batteries, in which the controller is further configured to determine a first battery for which an abnormality signal is sensed and at least one second battery related to the first battery among the plurality of batteries, based on the abnormality signal.

In an embodiment, the controller may be further configured to obtain temperature information of the plurality of batteries from a plurality of temperature measurement sensors that measure temperatures of the plurality of batteries, and determine a first battery for which an abnormal temperature is sensed and at least one second battery related to the first battery among the plurality of batteries, based on the temperature information.

In an embodiment, the controller may be further configured to determine the at least one second battery adjacent to the first battery based on an arrangement order of the plurality of batteries, when sensing an abnormal temperature or an abnormality signal of the first battery among the plurality of batteries.

In an embodiment, the controller may be further configured to calculate a capacity of the first battery and a capacity of the at least one second battery and compare the capacity of the first battery with the capacity of the second battery to control operations of the plurality of first switches and the plurality of second switches.

In an embodiment, when the capacity of the first battery exceeds the capacity of the at least one second battery, the controller may be further configured to turn on a first switch for connecting the first battery to a resistor connected to the first battery among the plurality of first switches and turn on at least any one second switch among the plurality of second switches.

In an embodiment, when the capacity of the first battery is less than the capacity of the at least one second battery, the controller may be further configured to turn on a first switch for connecting the second battery to a resistor connected to the second battery among the plurality of first switches and turn on at least any one second switch among the plurality of second switches.

An operating method of a battery management apparatus according to claim 9 is provided according to the present invention.

In an embodiment, the determining of whether each of the plurality of batteries is abnormal may include receiving an abnormality signal of the plurality of batteries from a battery management system (BMS) for each of the plurality of batteries and determining a first battery for which an abnormality signal is sensed and at least one second battery related to the first battery among the plurality of batteries, based on the abnormality signal.

In an embodiment, the determining of whether each of the plurality of batteries is abnormal may include obtaining temperature information of the plurality of batteries from a plurality of temperature measurement sensors that measure temperatures of the plurality of batteries and determining a first battery for which an abnormal temperature is sensed and at least one second battery related to the first battery among the plurality of batteries, based on the temperature information.

In an embodiment, the determining of whether each of the plurality of batteries is abnormal may include determining the at least one second battery adjacent to the first battery based on an arrangement order of the plurality of batteries, when sensing an abnormal temperature or an abnormality signal of the first battery among the plurality of batteries.

In an embodiment, the determining of whether each of the plurality of batteries is abnormal may include calculating a capacity of the first battery and a capacity of the at least one second battery and comparing the capacity of the first battery with the capacity of the second battery to control operations of the plurality of first switches and the plurality of second switches.

In an embodiment, the controlling of the operations of a plurality of first switches for respectively connecting a plurality of resistors respectively connected to the plurality of batteries to battery current output terminals of the plurality of batteries, based on whether each of the plurality of batteries is abnormal may include, when the capacity of the first battery exceeds the capacity of the at least one second battery, turning on a first switch for connecting the first battery to a resistor connected to the first battery among the plurality of first switches, and the controlling of the operations of a plurality of second switches connecting the plurality of resistors in parallel may include turning on at least any one second switch among the plurality of second switches.

In an embodiment, the controlling of the operations of a plurality of first switches for respectively connecting a plurality of resistors respectively connected to the plurality of batteries to battery current output terminals of the plurality of batteries, based on whether each of the plurality of batteries is abnormal may include, when the capacity of the first battery is less than the capacity of the at least one second battery, turning on a first switch for connecting the second battery to a resistor connected to the second battery among the plurality of first switches, and the controlling of the operations of a plurality of second switches connecting the plurality of resistors in parallel may include turning on at least any one second switch among the plurality of second switches.

### [ADVANTAGEOUS EFFECTS]

A battery management apparatus and an operating method thereof according to an embodiment disclosed herein may control a discharge rate and/or heating of a battery by using a plurality of resistors connected to one another in parallel.

Moreover, the battery management system and the operating method thereof according to an embodiment disclosed herein may stably manage the lifespan of a battery.

### [DESCRIPTION OF DRAWINGS]

FIG. 1 is a diagram conceptually showing a battery swapping station according to an embodiment disclosed herein.
FIG. 2 is a diagram conceptually showing a battery swapping station according to another embodiment disclosed herein.
FIG. 3 is a block diagram of a battery management apparatus according to an embodiment disclosed herein.
FIG. 4 is a circuit diagram for describing an operation of a battery management apparatus, according to an embodiment disclosed herein.
FIG. 5 is a flowchart of an operating method of a battery management apparatus according to an embodiment disclosed herein.
FIG. 6 is a flowchart showing an operating method of a battery management apparatus, according to another embodiment disclosed herein.
FIG. 7 is a block diagram showing a hardware configuration of a computing system for performing an operating method of a battery management apparatus, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

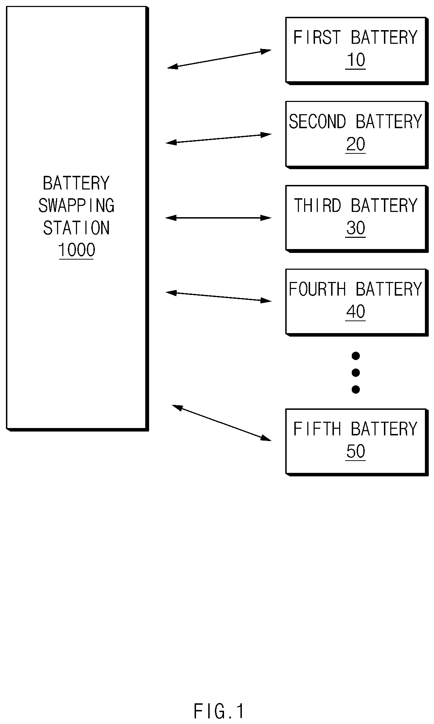

FIG. 1 is a diagram conceptually showing a battery swapping station according to an embodiment disclosed herein.

Referring to FIG. 1, a battery swapping system (BSS) 1000 may provide an overall management service for evaluation, measurement, charge, exchange, etc., of a battery, and in the present disclosure, a function of the battery swapping system 1000 will be described based on a battery swapping service. Herein, the battery swapping service may mean a service that analyzes states of a plurality of batteries 10, 20, 30, 40, and 50 that are service subjects and swaps the batteries 10, 20, 30, 40, and 50 with other batteries 10, 20, 30, 40, and 50 according to an analysis result. Such swapping may be automatically performed by a manager and/or user's setting. For example, the battery swapping station 1000 may provide a user with a battery swapping service by collecting the batteries 10, 20, 30, 40, and 50 returned from the user and providing other previously charged batteries 10, 20, 30, 40, and 50 to the user.

Herein, the batteries 10, 20, 30, 40, and 50 may be devices mounted on a subject device (e.g., an electrical transportation such as an electrical vehicle, an electrical scooter, an electrical bike, etc.) to supply power for driving the subject device, and may be implemented in the form of battery packs. The battery pack may include a battery that stores power and a battery management system (BMS) that controls an operation of the battery. The battery may include at least one battery cell for storing power under control of the BMS. The battery cell, which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and is not limited thereto. The BMS may control charge and discharge of the battery, and collect data that is a basis for state analysis of the battery and transmit the data to an external device at the request of the external device.

Hereinbelow, a description will be made assuming that the plurality of batteries 10, 20, 30, 40, and 50 are implemented in the form of battery packs. While it is illustrated in FIG. 1 that the number of batteries 10, 20, 30, 40, and 50 is 5, the batteries may include n batteries (n is a natural number greater than or equal to 2).

Depending on an embodiment, the battery swapping station 1000 may be arranged in a service station where the battery swapping service is provided or in a space that is separate from the service station.

The battery swapping station 1000 may analyze the states of the plurality of batteries 10, 20, 30, 40, and 50 connected thereto and swap the batteries 10, 20, and 30 with other batteries 10, 20, and 30 or reuse (i.e., not swap) the batteries 10, 20, and 30, according to a result of state analysis. The battery swapping station 1000 may autonomously determine whether state analysis with respect to the plurality of batteries 10, 20, 30, 40, and 50 and/or swapping of the batteries 10, 20, and 30 are required, but according to another embodiment, at least some operation may be performed in association with a server (e.g., a cloud server) connected through a network. For example, the battery swapping station 1000 may transmit to the cloud server, information that is a basis for determining whether swapping of a battery is required, and the cloud server may transmit to the battery swapping station 1000, the information about whether swapping of the battery is required.

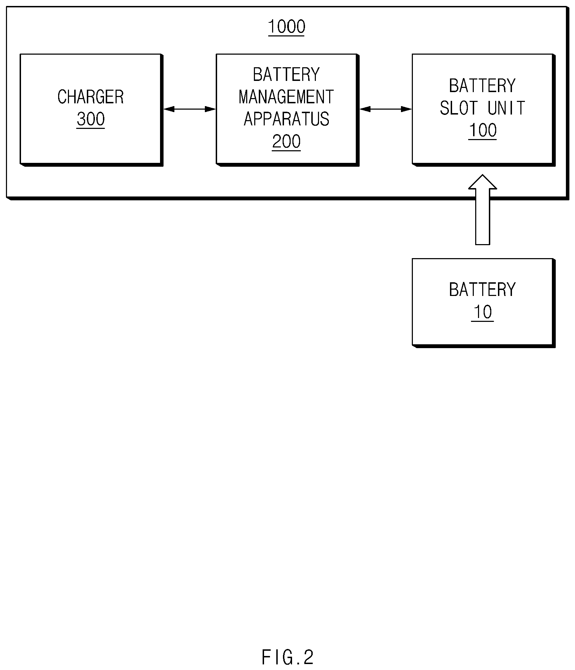

FIG. 2 is a diagram conceptually showing a battery swapping station according to another embodiment disclosed herein.

Referring to FIG. 2, the battery swapping station 1000 may include a battery slot unit 100, a battery management apparatus 200, and a charger 300.

The battery slot unit 100 may accommodate the plurality of batteries 10, 20, 30, 40, and 50 connected. The battery slot unit 100 may include a plurality of battery slots that respectively accommodate the plurality of batteries connected. The battery slot unit 100 may be connected to the battery management apparatus 200. The plurality of batteries 10, 20, 30, 40, and 50 accommodated in the battery slot unit 100 may be physically controlled based on a control signal of the battery management apparatus 200.

The battery management apparatus 200 may manage and/or control a state and/or an operation of the plurality of batteries 10, 20, 30, 40, and 50. The battery management apparatus 200 may manage charge and/or discharge of the plurality of batteries 10, 20, 30, 40, and 50.

In addition, the battery management apparatus 200 may monitor a voltage, a current, a temperature, etc., of each of the plurality of batteries 10, 20, 30, 40, and 50. The battery management apparatus 200 may calculate parameters indicating the states of the plurality of batteries 10, 20, 30, 40, and 50 based on measurement values of the monitored voltage, current, temperature, etc.

The battery management apparatus 200 may manage a state of charge (SoC) and/or a state of health (SoH) of the plurality of batteries 10, 20, 30, 40, and 50. The battery management apparatus 200 may receive SoC information of each of the plurality of batteries 10, 20, 30, 40, and 50 from the corresponding batteries 10, 20, 30, 40, and 50. Herein, the SoC information may indicate a current SoC of the corresponding battery and the SoC may mean a charge state of a battery included in the battery, i.e., a remaining capacity rate. A BMS for the corresponding battery may calculate the remaining capacity rate by dividing the current available capacity of the battery by a total capacity of the battery. For example, the remaining capacity rate may be calculated as a percentage. According to another embodiment, the battery management apparatus 200 may obtain SoC information by directly calculating a remaining capacity rate for a battery of the battery without receiving the SoC information from the BMS for the battery.

The charger 300 may charge each of the plurality of batteries 10, 20, 30, 40, and 50 under control of the battery management apparatus 200. The charger 300 may be supplied with power from an external utility power source to convert the power into a power form that may be received by the plurality of batteries 10, 20, 30, 40, and 50, and supply the power to the plurality of batteries 10, 20, 30, 40, and 50. According to an embodiment, the charger 300 may supply power until the SoCs of the plurality of batteries 10, 20, 30, 40, and 50 reach 100 %, thus fully charging the plurality of batteries 10, 20, 30, 40, and 50.

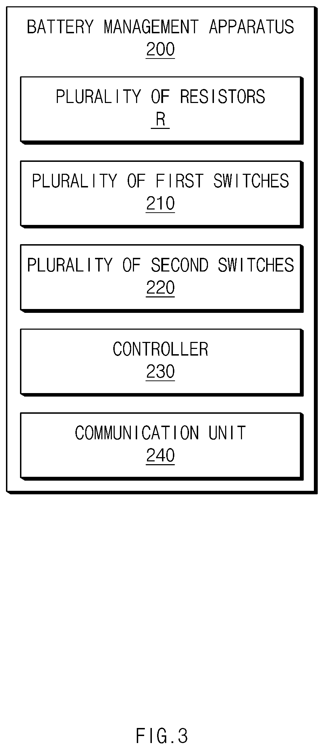

Hereinbelow, a configuration and an operation of the battery management apparatus 200 will be described in more detail with reference to FIG. 3.

FIG. 3 is a block diagram of a battery management apparatus according to an embodiment disclosed herein.

Referring to FIG. 3, the battery management apparatus 200 may include a plurality of resistors R, a plurality of first switches 210, a plurality of second switches 220, a controller 230, and a communication unit 240.

When any one of the plurality of batteries 10, 20, 30, 40, and 50 is the battery management apparatus 200 ignites, the battery management apparatus 200 may discharge an igniting battery or a nearby battery to remove fuel that is an energy source of the igniting battery or the nearby battery so as to suppress the spread of heat to the nearby battery or all the batteries. The battery management apparatus 200 may respectively connect the plurality of resistors R to the exterior of the plurality of batteries 10, 20, 30, 40, and 50 and apply discharge current to each resistor to discharge the batteries,

Herein, the discharge rate of the battery may be determined by the resistance value of the plurality of resistors R, and the resistance value needs to be changed to adjust the discharge rate of the battery. Thus, the battery management apparatus 200 may connect the plurality of resistors R in parallel and distribute discharge current to the plurality of resistors R connected in parallel to adjust the discharge current value, thus controlling the discharge rate.

The plurality of resistors R may be serially connected to the plurality of batteries 10, 20, 30, 40, and 50. In addition, the plurality of resistors R may be respectively connected to the plurality of first switches 210 in series. More specifically, as the plurality of first switches 210 are turned on, the plurality of resistors R may be respectively connected in series to the plurality of batteries 10, 20, 30, 40, and 50 serially connected to the first switches 210, thus discharging the batteries.

The plurality of resistors R may be connected to one another in parallel, and may be selectively connected in parallel based on the plurality of first switches 210 respectively connected thereto being turned on/off. More specifically, as any one of the plurality of first switches 210 respectively connected in series to the plurality of resistors R is selectively turned on, the resistors R connected to the plurality of first switches 210 in the on state among the plurality of resistors R connected in parallel may be connected to one another in parallel.

That is, some of the plurality of resistors R may be selectively connected in parallel based on the plurality of first switches 210 being on or off. Thus, resistance values of the plurality of resistors R may be changed, such that discharge rates of the plurality of batteries 10, 20, 30, 40, and 50 may be changed.

The plurality of first switches 210 may respectively connect the plurality of resistors R to output terminals of the plurality of batteries 10, 20, 30, 40, and 50. The plurality of first switches 210 may be respectively connected to the plurality of batteries 10, 20, 30, 40, and 50 in series. The plurality of first switches 210 may be respectively connected to the plurality of resistors R in series.

Each of the plurality of first switches 210 may receive a control signal from the controller 230, thus being turned on or off.

The plurality of second switches 220 may be connected to the plurality of resistors R in parallel. The plurality of second switches 220 may be serially connected to one another. Each of the plurality of second switches 220 may receive a control signal from the controller 230, thus being turned on or off.

The communication unit 240 may wiredly and/or wirelessly communicate with a BMS for each of the plurality of batteries 10, 20, 30, 40, and 50. For example, the communication unit 240 may communicate with a BMS for each of the plurality of batteries 10, 20, 30, 40, and 50 according to a differential input communication protocol. Herein, examples of the differential input communication protocol may include a controller area network (CAN). In addition, the communication unit 240 may communicate with a BMS for each of the plurality of batteries 10, 20, 30, 40, and 50 according to a wireless communication protocol such as WiFi (a registered trademark), Bluetooth (a registered trademark), etc.

According to an embodiment, the communication unit 240 may periodically communicate with a BMS for each of the plurality of batteries 10, 20, 30, 40, and 50. When a BMS for any one of the plurality of batteries 10, 20, 30, 40, and 50 does not transmit a communication signal after an elapse of a specific period, the communication unit 240 may transmit a communication signal to the BMS for any one of the plurality of batteries 10, 20, 30, 40, and 50.

According to an embodiment, the communication unit 240 may receive an abnormality signal of the battery from the BMS for any one of the plurality of batteries 10, 20, 30, 40, and 50.

The controller 230 may determine whether each of the plurality of batteries 10, 20, 30, 40, and 50 is abnormal.

According to an embodiment, when the communication unit 240 does not receive a communication signal after an elapse of a specific period from a BMS for any one of the plurality of batteries 10, 20, 30, 40, and 50 and does not receive the communication signal even after repeatedly retrying transmission of a communication signal to the BMS for any one of the plurality of batteries 10, 20, 30, 40, and 50, the controller 230 may determine any one of the plurality of batteries 10, 20, 30, 40, and 50 to be an abnormal battery.

According to an embodiment, when the communication unit 240 receives an abnormality signal from any one of the plurality of batteries 10, 20, 30, 40, and 50, the controller 230 may determine the any one of the plurality of batteries 10, 20, 30, 40, and 50 to be an abnormal battery.

According to an embodiment, the controller 230 may receive temperature information of the plurality of batteries 10, 20, 30, 40, and 50 from a plurality of temperature measurement sensors mounted in the battery slot unit 100, and may determine any one of the plurality of batteries 10, 20, 30, 40, and 50 to be an abnormal battery when a temperature of the any one of the plurality of batteries 10, 20, 30, 40, and 50 exceeds a threshold temperature based on the temperature information.

For example, the controller 230 may determine, as the abnormal battery, the first battery 10 among the plurality of batteries 10, 20, 30, 40, and 50 for which an abnormal temperature or an abnormality signal is sensed. The controller 230 may determine at least one second battery 20 related to the first battery 10 determined as the abnormal battery. For example, the controller 230 may determine at least one second battery 20 adjacent to the first battery 10 based on a previously stored arrangement order of the plurality of batteries 10, 20, 30, 40, and 50.

The controller 230 may control operations of the plurality of first switches 210 and the plurality of second switches 220 based on whether the plurality of batteries 10, 20, 30, 40, and 50 are abnormal.

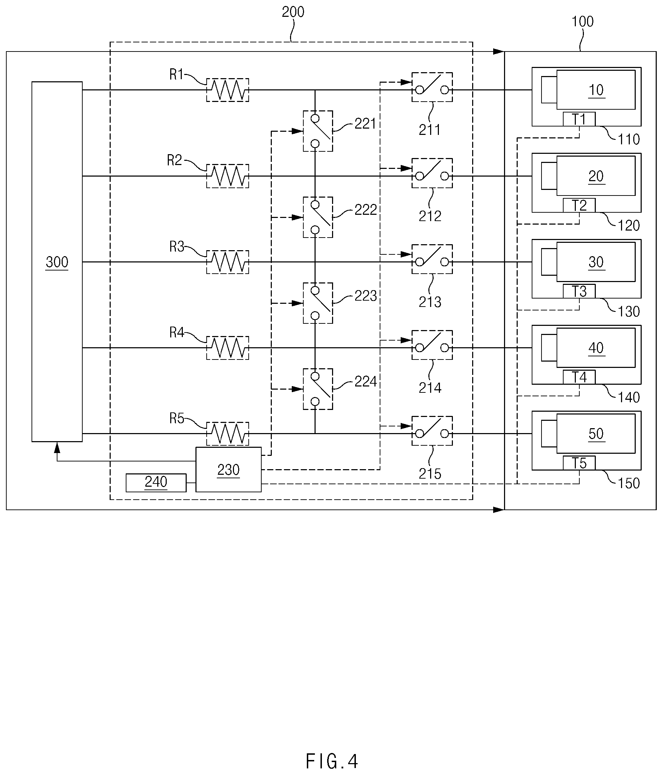

FIG. 4 is a circuit diagram for describing an operation of a battery management apparatus, according to an embodiment disclosed herein.

Hereinbelow, an operation of the battery management apparatus will be described in detail with reference to FIG. 4.

While it is shown in FIG. 4 that five batteries 10, 20, 30, 40, and 50 for receiving a battery swapping service are connected to the battery swapping system 1000, the scope of the present disclosure is not limited thereto and n batteries (n is a natural number of 2 or greater) for receiving the battery swapping service may be connected to the battery swapping system 1000.

Referring to FIG. 4, the battery slot unit 100 may include a plurality of battery slots 110, 120, 130, 140, and 150. Each of the plurality of battery slots 110, 120, 130, 140, and 150 may include any one of the plurality of batteries 10, 20, 30, 40, and 50.

The plurality of battery slots 110, 120, 130, 140, and 150 may respectively include temperature measurement sensors T1, T2, T3, T4, and T5. The plurality of temperature measurement sensors T1, T2, T3, T4, and T5 may measure temperatures of the plurality of batteries 10, 20, 30, 40, and 50. For example, the plurality of temperature measurement sensors T1, T2, T3, T4, and T5 may include a plurality of thermistors. A thermistor may mean a resistor having a resistance sensitively changing with a temperature, and the thermistor may measure a temperature by using a resistance change of a ceramic material with respect to a temperature. The temperature of the thermistor may increase due to occurrence of a self-heating phenomenon when current is applied thereto.

According to an embodiment, the controller 230 may obtain temperature information of the plurality of batteries 10, 20, 30, 40, and 50 from the plurality of temperature measurement sensors T1, T2, T3, T4, and T5 that measure the temperatures of the plurality of batteries 10, 20, 30, 40, and 50. For example, the controller 230 may determine, as the abnormal battery, the first battery 10 among the plurality of batteries 10, 20, 30, 40, and 50 for which an abnormal temperature is sensed.

In addition, for example, when the communication unit 240 does not receive a communication signal after an elapse of a specific period from a BMS for the first battery 10 of the plurality of batteries 10, 20, 30, 40, and 50 and does not receive the communication signal even after repeatedly retrying transmission of a communication signal to the BMS for the first battery 10, the controller 230 may determine the first battery 10 to be an abnormal battery.

In addition, for example, when the communication unit 240 receives an abnormality signal of the battery from the first battery 10 of the plurality of batteries 10, 20, 30, 40, and 50, the controller 230 may determine the first battery 10 as an abnormal battery.

When determining that the first battery 10 as an abnormal battery, the controller 230 may transmit a charge stop signal of the plurality of batteries 10, 20, 30, 40, and 50 to the charger 300.

The controller 230 may calculate capacities of the first battery 10 and the second battery 20. The controller 230 may receive battery data through communication with a BMS for the first battery 10 and a BMS for the second battery 10. Herein, the battery data may include, for example, a voltage of the battery, a voltage of a battery cell of the battery, a fault signal, an internal temperature of the battery, etc. The controller 230 may calculate capacities of the first battery 10 and the second battery 20 based on the battery data of the first battery 10 and the second battery 20.

The controller 230 may control operations of the plurality of first switches 210 and the plurality of second switches 220 by comparing the capacity of the first battery 10 with the capacity of the second battery 20.

According to an embodiment, when the capacity of the first battery 10 exceeds the capacity of the second battery 20, the controller 230 may discharge the first battery 10 until the capacity of the first battery 10 is equal to the capacity of the second battery 20. For example, when the capacity of the first battery 10 is 8000 mA, a voltage of the first battery 10 is 60 V, the capacity of the second battery 20 is 4000 mAh, and a voltage of the second battery 20 is 50 V, the controller 230 may discharge the first battery 10 until the capacity of the first battery 10 is equal to the capacity of the second battery 20. The controller 230 may turn on, among the plurality of first switches 210, a first switch 211 for connecting the first battery 10 to a first resistor R1 connected to the first battery 10, and turn off the plurality of other first switches 212, 213, 214, and 215.

The controller 230 may turn on at least any one second switch of the plurality of second switches 220 to adjust a distribution ratio of discharge current of the first battery 10 applied to the plurality of resistors R.

For example, when the discharge current of the first battery 10 is 10 A and the voltage of the first battery 10 is 60 V, the controller 230 may turn on some of the plurality of second switches 220 and turn off some others to control the plurality of resistor R values to be 60 V/10 A= 6 ohm.

For example, when a resistance value of each of the plurality of resistors R is 24 ohm, the controller 230 may connect a first resistor R1, a second resistor R2, a third resistor R3, and a fourth resistor R4 among the plurality of resistors R in parallel to control a total resistance value of the first resistor R1, the second resistor R2, the third resistor R3, and the fourth resistor R4 connected in parallel to be 6 ohm. More specifically, the controller 230 may turn on some second switches 221, 222 and 223 capable of connecting the first resistor R1, the second resistor R2, the third resistor R3, and the fourth resistor R4 in parallel among the plurality of second switches 220, and turn off a second switch 224 capable of connecting a fifth resistor R5 in parallel.

According to an embodiment, when the capacity of the first battery 10 is less than the capacity of the second battery 20, the controller 230 may discharge the second battery 20 until the capacity of the second battery 20 is equal to the capacity of the first battery 10. For example, when the capacity of the first battery 10 is 4000 mA, the voltage of the first battery 10 is 50 V, the capacity of the second battery 20 is 8000 mAh, and the voltage of the second battery 20 is 60 V, the controller 230 may discharge the second battery 20 until the capacity of the second battery 20 is equal to the capacity of the first battery 10. The controller 230 may turn on, among the plurality of first switches 210, the first switch 212 for connecting the second battery 20 to a second resistor R2 connected to the second battery 20, and turn off the plurality of other first switches 211, 213, 214, and 215.

The controller 230 may turn on at least any one second switch of the plurality of second switches 220 to adjust a distribution ratio of discharge current of the second battery 20 applied to the plurality of resistors R.

For example, when the discharge current of the second battery 20 is 10 A and the voltage of the second battery 20 is 60 V, the controller 230 may turn on some of the plurality of second switches 220 and turn off some others to control the plurality of resistor R values to be 60 V/10 A = 6 ohm.

For example, when a resistance value of each of the plurality of resistors R is 24 ohm, the controller 230 may connect a first resistor R1, a second resistor R2, a third resistor R3, and a fourth resistor R4 among the plurality of resistors R in parallel to control a total resistance value of the first resistor R1, the second resistor 2, the third resistor R3, and the fourth resistor R4 connected in parallel to be 6 ohm. More specifically, the controller 230 may turn on some second switches 221, 222 and 223 capable of connecting the first resistor R1, the second resistor R2, the third resistor R3, and the fourth resistor R4 in parallel among the plurality of second switches 220, and turn off a second switch 224 capable of connecting a fifth resistor R5 in parallel.

According to an embodiment, when the capacity of the first battery 10 is equal to the capacity of the second battery 20, the controller 230 may discharge the first battery 10 and the second battery 20 at the same time.

The controller 230 may turn on, among the plurality of first switches 210, the first switch 211 for connecting the first battery 10 to the first resistor R1 connected to the first battery 10, turn on the first switch 212 for connecting the second battery 20 to the second resistor R2 connected to the second battery 20, and turn off the plurality of other first switches 213, 214, and 215. In addition, the controller 230 may turn on at least any one second switch of the plurality of second switches 220 to adjust a distribution ratio of discharge currents of the first battery 10 and the second battery 20 applied to the plurality of resistors R.

As described above, the battery management apparatus according to an embodiment disclosed herein may control a discharge rate and heating by using a plurality of resistors connected to one another in parallel.

When a dangerous situation and abnormality occur in some batteries, the battery management apparatus may forcedly discharge an abnormal battery and a nearby battery to prevent a chain accident from occurring on the nearby battery, thereby stably operating the battery swapping station.

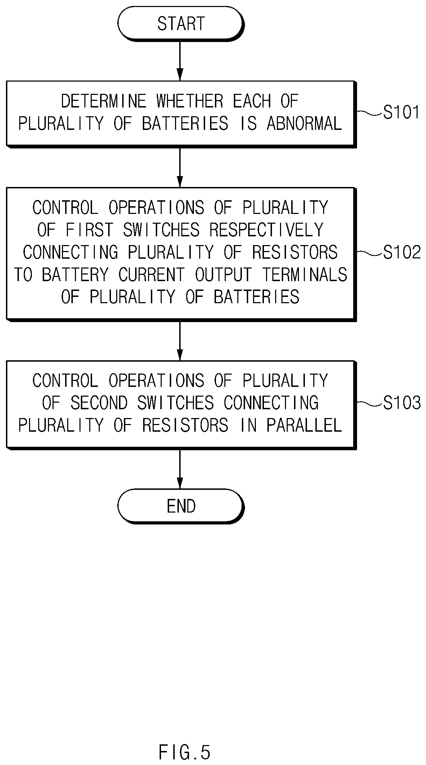

FIG. 5 is a flowchart of an operating method of a battery management apparatus according to an embodiment disclosed herein.

Referring to FIG. 5, the operating method of the battery management apparatus according to an embodiment disclosed herein may include operation S101 of determining whether each of a plurality of batteries is abnormal, operation S102 of controlling operations of a plurality of first switches for connecting a plurality of resistors respectively connected to the plurality of batteries to battery current output terminals of the plurality of batteries, based on whether each of the plurality of batteries is abnormal, and operation S103 of controlling operations of a plurality of second switches for connecting the plurality of resistors in parallel.

Hereinbelow, operations S101 through S103 will be described in detail with reference to FIGS. 1 and 4. The battery management apparatus 200 may be substantially the same as the battery management apparatus 200 described with reference to FIGS. 1 to 4, and thus will be briefly described to avoid redundant description.

In operation S101, the controller 230 may determine whether each of the plurality of batteries 10, 20, 30, 40, and 50 is abnormal.

In operation S101, when the communication unit 240 does not receive a communication signal after an elapse of a specific period from a BMS for any one of the plurality of batteries 10, 20, 30, 40, and 50 and does not receive the communication signal even after repeatedly retrying transmission of a communication signal to the BMS for any one of the plurality of batteries 10, 20, 30, 40, and 50, the controller 230 may determine any one of the plurality of batteries 10, 20, 30, 40, and 50 to be an abnormal battery.

In operation S101, when the communication unit 240 receives an abnormality signal from any one of the plurality of batteries 10, 20, 30, 40, and 50, the controller 230 may determine the any one of the plurality of batteries 10, 20, 30, 40, and 50 to be an abnormal battery.

In operation S101, the controller 230 may receive temperature information of the plurality of batteries 10, 20, 30, 40, and 50 from a plurality of temperature measurement sensors mounted in the battery slot unit 100, and may determine any one of the plurality of batteries 10, 20, 30, 40, and 50 to be an abnormal battery when a temperature of the any one of the plurality of batteries 10, 20, 30, 40, and 50 exceeds a threshold temperature based on the temperature information.

In operation S101, the controller 230 may determine, as the abnormal battery, the first battery 10 among the plurality of batteries 10, 20, 30, 40, and 50 for which an abnormal temperature or an abnormality signal is sensed. The controller 230 may determine at least one second battery 20 related to the first battery 10 determined as the abnormal battery. In operation S101, for example, the controller 230 may determine at least one second battery 20 adjacent to the first battery 10 based on a previously stored arrangement order of the plurality of batteries 10, 20, 30, 40, and 50.

In operation S102, the controller 230 may control operations of the plurality of first switches 210, based on whether the plurality of batteries 10, 20, 30, 40, and 50 are abnormal.

In operation S102, the controller 230 may control operations of the plurality of first switches 210 by comparing the capacity of the first battery 10 with the capacity of the second battery 20.

In operation S103, the controller 230 may control operations of the plurality of first switches 210, based on whether the plurality of batteries 10, 20, 30, 40, and 50 are abnormal.

In operation S103, the controller 230 may turn on at least any one second switch of the plurality of second switches 220 to adjust a distribution ratio of discharge current of the first battery 10 applied to the plurality of resistors R.

In operation S103, for example, when the discharge current of the first battery 10 is 10 A and the voltage of the first battery 10 is 60 V, the controller 230 may turn on some of the plurality of second switches 220 and turn off some others to control the plurality of resistor R values to be 60 V/10 A = 6 ohm.

In operation S103, for example, when a resistance value of each of the plurality of resistors R is 24 ohm, the controller 230 may connect a first resistor R1, a second resistor R2, a third resistor R3, and a fourth resistor R4 among the plurality of resistors R in parallel to control a total resistance value of the first resistor R1, the second resistor R2, the third resistor R3, and the fourth resistor R4 connected in parallel to be 6 ohm. In operation S103, more specifically, the controller 230 may turn on some second switches 221, 222 and 223 capable of connecting the first resistor R1, the second resistor R2, the third resistor R3, and the fourth resistor R4 in parallel among the plurality of second switches 220, and turn off a second switch 224 capable of connecting a fifth resistor R5 in parallel.

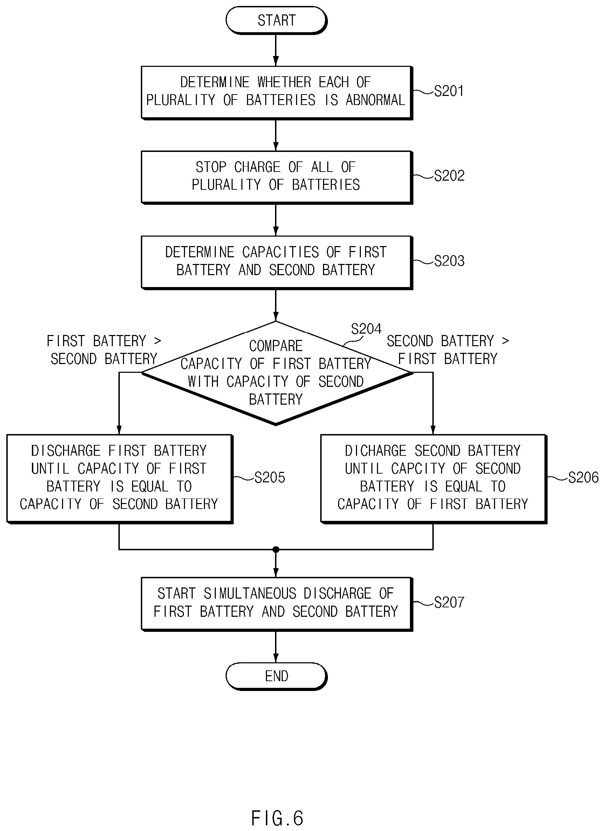

FIG. 6 is a flowchart showing an operating method of a battery management apparatus, according to another embodiment disclosed herein.

Referring to FIG. 6, the operating method of the battery management apparatus according to an embodiment disclosed herein may include operation S201 of determining whether each of a plurality of batteries is abnormal, operation S202 of stopping charge of all of the plurality of batteries, operation S203 of determining capacities of a first battery and a second battery, operation S204 of comparing the capacity of the first battery with the capacity of the second battery, operation S205 of discharging the first battery until the capacity of the first battery is equal to the capacity of the second battery, operation S206 of discharging the second battery until the capacity of the second battery is equal to the capacity of the first battery, and operation S207 of starting simultaneous discharge of the first battery and the second battery.

Hereinbelow, operations S201 through S207 will be described in detail with reference to FIGS. 1 and 4. The battery management apparatus 200 may be substantially the same as the battery management apparatus 200 described with reference to FIGS. 1 to 4, and thus will be briefly described to avoid redundant description.

In operation S201, the controller 230 may determine whether each of the plurality of batteries 10, 20, 30, 40, and 50 is abnormal.

In operation S201, the controller 230 may determine, as the abnormal battery, the first battery 10 among the plurality of batteries 10, 20, 30, 40, and 50 for which an abnormal temperature or an abnormality signal is sensed. In operation S201, the controller 230 may determine at least one second battery 20 related to the first battery 10 determined as the abnormal battery. In operation S201, for example, the controller 230 may determine at least one second battery 20 adjacent to the first battery 10 based on a previously stored arrangement order of the plurality of batteries 10, 20, 30, 40, and 50.

In operation S202, the controller 230 may stop charge of the plurality of batteries 10, 20, 30, 40, and 50. In operation S202, the controller 230 may transmit a charge stop signal for the first battery 10 determined as the abnormal battery and the second battery 20 adjacent to the first battery 10 to the charger 300.

In operation S203, the controller 230 may calculate the capacities of the first battery 10 determined as the abnormal battery and the second battery 20. In operation S203, the controller 230 may receive battery data through communication with a BMS for the first battery 10 and a BMS for the second battery 10. Herein, the battery data may include, for example, a voltage of the battery, a voltage of a battery cell of the battery, a fault signal, an internal temperature of the battery, etc. In operation S203, the controller 230 may calculate capacities of the first battery 10 and the second battery 10 based on the battery data of the first battery 10 and the second battery 20.

In operation S204, the controller 230 may compare the capacity of the first battery 10 with the capacity of the second battery 20.

In operation S205, the controller 230 may control operations of the plurality of first switches 210 by comparing the capacity of the first battery 10 with the capacity of the second battery 20.

In operation S205, when the capacity of the first battery 10 exceeds the capacity of the second battery 20, the controller 230 may discharge the first battery 10 until the capacity of the first battery 10 is equal to the capacity of the second battery 20. In operation S205, for example, when the capacity of the first battery 10 is 8000 mA, a voltage of the first battery 10 is 60 V, the capacity of the second battery 20 is 4000 mAh, and a voltage of the second battery 20 is 50 V, the controller 230 may discharge the first battery 10 until the capacity of the first battery 10 is equal to the capacity of the second battery 20. In operation S102, the controller 230 may turn on, among the plurality of first switches 210, the first switch 211 for connecting the first battery 10 to the first resistor R1 connected to the first battery 10, and turn off the plurality of other first switches 212, 213, 214, and 215.

In operation S206, when the capacity of the first battery 10 is less than the capacity of the second battery 20, the controller 230 may discharge the second battery 20 until the capacity of the second battery 20 is equal to the capacity of the first battery 10. In operation S206, for example, when the capacity of the first battery 10 is 4000 mA, the voltage of the first battery 10 is 50 V, the capacity of the second battery 20 is 8000 mAh, and the voltage of the second battery 20 is 60 V, the controller 230 may discharge the second battery 20 until the capacity of the second battery 20 is equal to the capacity of the first battery 10. In operation S206, the controller 230 may turn on, among the plurality of first switches 210, the first switch 212 for connecting the second battery 20 to the second resistor R2 connected to the second battery 20, and turn off the plurality of other first switches 211, 213, 214, and 215.

In operation S207, when the capacity of the first battery 10 is equal to the capacity of the second battery 20, the controller 230 may discharge the first battery 10 and the second battery 20 at the same time.

In operation S207, the controller 230 may turn on, among the plurality of first switches 210, the first switch 211 for connecting the first battery 10 to the first resistor R1 connected to the first battery 10, turn on the first switch 212 for connecting the second battery 20 to the second resistor R2 connected to the second battery 20, and turn off the plurality of other first switches 213, 214, and 215. In operation S207, in addition, the controller 230 may turn on at least any one second switch of the plurality of second switches 220 to adjust a distribution ratio of discharge currents of the first battery 10 and the second battery 20 applied to the plurality of resistors R.

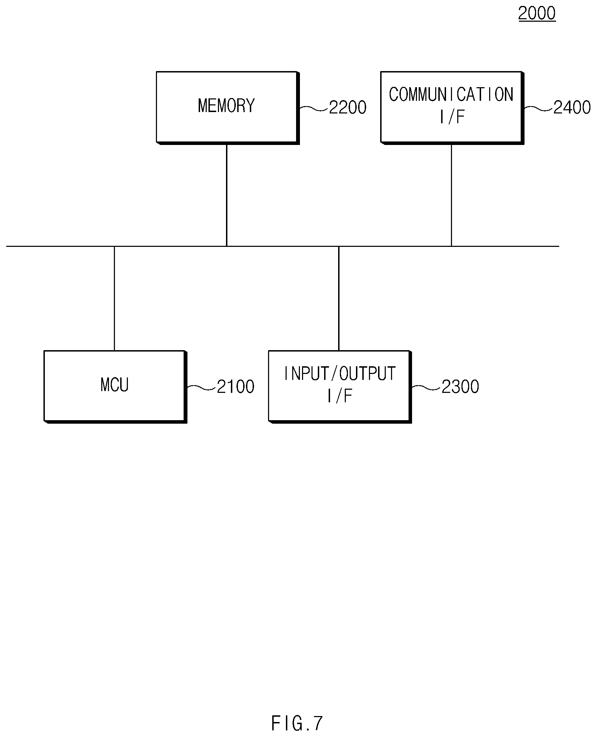

FIG. 7 is a block diagram showing a hardware configuration of a computing system for performing an operating method of a battery management apparatus, according to an embodiment disclosed herein.

Referring to FIG. 7, a computing system 2000 according to an embodiment disclosed herein may include an MCU 2100, a memory 2200, an input/output I/F 2300, and a communication I/F 2400.

The MCU 2100 may be a processor that executes various programs (e.g., a battery capacity calculation program) stored in the memory 2200, processes various data including an SOC, an SOH, etc., of a plurality of battery cells through these programs, executes functions of the battery management apparatus 200 described above with reference to FIG. 1, or executes the operating method of the battery management apparatus described with reference to FIG. 4.

The memory 2200 may store various programs regarding SOH calculation of the battery cell, cell target determination, etc. Moreover, the memory 2200 may store various data such as SOC data, SOH data, etc., of each battery cell.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 220 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2300, which is a component capable of transmitting and receiving various data to and from a server, may be various devices capable of supporting wired or wireless communication. For example, a program for SOH calculation of the battery cell or target determination or various data, etc., may be transmitted and received to and from a separately provided external server through the communication I/F 2300.

As such, an operating method of a battery management apparatus according to an embodiment disclosed herein may be recorded in the memory 2200 and executed by the MCU 2100.

## Claims

1. A battery management apparatus comprising:
a plurality of resistors (R) respectively connected to a plurality of batteries (10, 20, 30, 40, 50);
a plurality of first switches (210) configured to respectively connect the plurality of resistors (R) to output terminals of the plurality of batteries (10, 20, 30, 40, 50), wherein each of the plurality of first switches is connected to a corresponding resistor at a first node;
a plurality of second switches (220) configured to connect the plurality of resistors (R) in parallel wherein each of the plurality of second switches is connected between two adjacent first nodes of two adjacent first switches in the plurality of first switches; and
a controller (230) configured to determine whether at least one of the plurality of batteries (10, 20, 30, 40, 50) is abnormal, and control operations of the plurality of first switches (210) and the plurality of second switches (220) for discharging at least a part of the plurality of batteries via the resistors connected in parallel based on whether at least one of the plurality of batteries (10, 20, 30, 40, 50) is abnormal.

2. The battery management apparatus of claim 1, wherein the plurality of resistors (R) are respectively connected to the plurality of batteries (10, 20, 30, 40, 50) in series, and
the plurality of second switches (220) are serially connected to one another.

3. The battery management apparatus of claim 2, further comprising a communication unit (240) configured to receive an abnormality signal of the plurality of batteries (10, 20, 30, 40, 50) from a battery management system (BMS) for each of the plurality of batteries (10, 20, 30, 40, 50),
wherein the controller (230) is further configured to determine a first battery (10) for which an abnormality signal is sensed and at least one second battery (20) related to the first battery (10) among the plurality of batteries (10, 20, 30, 40, 50), based on the abnormality signal.

4. The battery management apparatus of claim 3, wherein the controller (230) is further configured to obtain temperature information of the plurality of batteries (10, 20, 30, 40, 50) from a plurality of temperature measurement sensors (T1, T2, T3, T4, T5) that measure temperatures of the plurality of batteries (10, 20, 30, 40, 50), and determine a first battery (10) for which an abnormal temperature is sensed and at least one second battery (20) related to the first battery (10) among the plurality of batteries (10, 20, 30, 40, 50), based on the temperature information.

5. The battery management apparatus of claim 4, wherein the controller (230) is further configured to determine the at least one second battery (20) adjacent to the first battery (10) based on an arrangement order of the plurality of batteries (10, 20, 30, 40, 50), when sensing an abnormal temperature or an abnormality signal of the first battery (10) among the plurality of batteries (10, 20, 30, 40, 50).

6. The battery management apparatus of claim 4, wherein the controller (230) is further configured to calculate a capacity of the first battery (10) and a capacity of the at least one second battery (20) and compare the capacity of the first battery (10) with the capacity of the second battery to control operations of the plurality of first switches (210) and the plurality of second switches (220).

7. The battery management apparatus of claim 6, wherein, when the capacity of the first battery (10) exceeds the capacity of the at least one second battery (20), the controller (230) is further configured to turn on a first switch for connecting the first battery (10) to a resistor connected to the first battery (10) among the plurality of first switches (210) and turn on at least any one second switch among the plurality of second switches (220).

8. The battery management apparatus of claim 6, wherein, when the capacity of the first battery (10) is less than the capacity of the at least one second battery (20), the controller (230) is further configured to turn on a first switch for connecting the second battery to a resistor connected to the second battery among the plurality of first switches (210) and turn on at least any one second switch among the plurality of second switches (220).

9. An operating method of a battery management apparatus, the operating method comprising:
determining whether at least one of the plurality of batteries (10, 20, 30, 40, 50) is abnormal;
controlling operations of a plurality of first switches (210) for respectively connecting a plurality of resistors (R) respectively connected to the plurality of batteries (10, 20, 30, 40, 50) to battery current output terminals of the plurality of batteries (10, 20, 30, 40, 50), based on whether at least one of the plurality of batteries (10, 20, 30, 40, 50) is abnormal; and
controlling operations of a plurality of second switches (220) connecting the plurality of resistors (R) in parallel for discharging at least a part of the plurality of batteries via the resistors connected in parallel, wherein each of the plurality of first switches is connected to a corresponding resistor at a first node, and
wherein each of the plurality of second switches is connected between two adjacent first nodes of two adjacent first switches in the plurality of first switches.

10. The operating method of claim 9, wherein the determining of whether each of the plurality of batteries (10, 20, 30, 40, 50) is abnormal comprises:
receiving an abnormality signal of the plurality of batteries (10, 20, 30, 40, 50) from a battery management system (BMS) for each of the plurality of batteries (10, 20, 30, 40, 50); and
determining a first battery (10) for which an abnormality signal is sensed and at least one second battery (20) related to the first battery (10) among the plurality of batteries (10, 20, 30, 40, 50), based on the abnormality signal.

11. The operating method of claim 10, wherein the determining of whether each of the plurality of batteries (10, 20, 30, 40, 50) is abnormal comprises:
obtaining temperature information of the plurality of batteries (10, 20, 30, 40, 50) from a plurality of temperature measurement sensors (T1, T2, T3, T4, T5) that measure temperatures of the plurality of batteries (10, 20, 30, 40, 50); and
determining a first battery (10) for which an abnormal temperature is sensed and at least one second battery (20) related to the first battery (10) among the plurality of batteries (10, 20, 30, 40, 50), based on the temperature information.

12. The operating method of claim 11, wherein the determining of whether each of the plurality of batteries (10, 20, 30, 40, 50) is abnormal comprises determining the at least one second battery (20) adjacent to the first battery (10) based on an arrangement order of the plurality of batteries (10, 20, 30, 40, 50), when sensing an abnormal temperature or an abnormality signal of the first battery (10) among the plurality of batteries (10, 20, 30, 40, 50).

13. The operating method of claim 12, wherein the determining of whether each of the plurality of batteries (10, 20, 30, 40, 50) is abnormal comprises calculating a capacity of the first battery (10) and a capacity of the at least one second battery (20) and comparing the capacity of the first battery (10) with the capacity of the second battery to control operations of the plurality of first switches (210) and the plurality of second switches (220).

14. The operating method of claim 13, wherein the controlling of the operations of a plurality of first switches (210) for respectively connecting a plurality of resistors (R) respectively connected to the plurality of batteries (10, 20, 30, 40, 50) to battery current output terminals of the plurality of batteries (10, 20, 30, 40, 50), based on whether each of the plurality of batteries (10, 20, 30, 40, 50) is abnormal comprises, when the capacity of the first battery (10) exceeds the capacity of the at least one second battery (20), turning on a first switch for connecting the first battery (10) to a resistor connected to the first battery (10) among the plurality of first switches (210), and
the controlling of the operations of a plurality of second switches (220) connecting the plurality of resistors (R) in parallel comprises turning on at least any one second switch among the plurality of second switches (220).

15. The operating method of claim 13, wherein the controlling of the operations of a plurality of first switches (210) for respectively connecting a plurality of resistors (R) respectively connected to the plurality of batteries (10, 20, 30, 40, 50) to battery current output terminals of the plurality of batteries (10, 20, 30, 40, 50), based on whether each of the plurality of batteries (10, 20, 30, 40, 50) is abnormal comprises, when the capacity of the first battery (10) is less than the capacity of the at least one second battery (20), turning on a first switch for connecting the second battery to a resistor connected to the second battery among the plurality of first switches (210), and
the controlling of the operations of a plurality of second switches (220) connecting the plurality of resistors (R) in parallel comprises turning on at least any one second switch among the plurality of second switches (220).

## Patentansprüche

1. Batteriemanagementvorrichtung, umfassend:
eine Vielzahl von Widerständen (R), die jeweils mit einer Vielzahl von Batterien (10, 20, 30, 40, 50) geschaltet sind;
eine Vielzahl von ersten Schaltern (210), die dazu konfiguriert sind, die Vielzahl von Widerständen (R) jeweils mit Ausgangsanschlüssen der Vielzahl von Batterien (10, 20, 30, 40, 50) zu schalten, wobei jeder der Vielzahl von ersten Schaltern mit einem entsprechenden Widerstand an einem ersten Knoten geschaltet ist;
eine Vielzahl von zweiten Schaltern (220), die dazu konfiguriert sind, die Vielzahl von Widerständen (R) parallel zu schalten, wobei jeder der Vielzahl von zweiten Schaltern zwischen zwei benachbarten ersten Knoten von zwei benachbarten ersten Schaltern in der Vielzahl von ersten Schaltern geschaltet ist; und
eine Steuerung (230), die dazu konfiguriert ist, zu bestimmen, ob mindestens eine der Vielzahl von Batterien (10, 20, 30, 40, 50) anormal ist, und Operationen der Vielzahl von ersten Schaltern (210) und der Vielzahl von zweiten Schaltern (220) zum Entladen mindestens eines Teils der Vielzahl von Batterien über die parallel geschalteten Widerstände zu steuern, basierend darauf, ob mindestens eine der Vielzahl von Batterien (10, 20, 30, 40, 50) anormal ist.

2. Batteriemanagementvorrichtung nach Anspruch 1, wobei die Vielzahl von Widerständen (R) jeweils mit der Vielzahl von Batterien (10, 20, 30, 40, 50) in Reihe geschaltet ist, und
die Vielzahl von zweiten Schaltern (220) miteinander in Reihe geschaltet ist.

3. Batteriemanagementvorrichtung nach Anspruch 2, ferner umfassend eine Kommunikationseinheit (240), die dazu konfiguriert ist, ein Anomaliesignal der Vielzahl von Batterien (10, 20, 30, 40, 50) von einem Batteriemanagementsystem (BMS) für jede der Vielzahl von Batterien (10, 20, 30, 40, 50) zu empfangen,
wobei die Steuerung (230) ferner dazu konfiguriert ist, eine erste Batterie (10), für die ein Anomaliesignal erfasst wird, und mindestens eine zweite Batterie (20), die sich auf die erste Batterie (10) bezieht, aus der Vielzahl von Batterien (10, 20, 30, 40, 50) basierend auf dem Anomaliesignal zu bestimmen.

4. Batteriemanagementvorrichtung nach Anspruch 3, wobei die Steuerung (230) ferner dazu konfiguriert ist, Temperaturinformationen der Vielzahl von Batterien (10, 20, 30, 40, 50) von einer Vielzahl von Temperaturmesssensoren (T1, T2, T3, T4, T5) zu erhalten, die Temperaturen der Vielzahl von Batterien (10, 20, 30, 40, 50) messen, und eine erste Batterie (10), für die eine anormale Temperatur erfasst wird, und mindestens eine zweite Batterie (20), die sich auf die erste Batterie (10) bezieht, aus der Vielzahl von Batterien (10, 20, 30, 40, 50) basierend auf den Temperaturinformationen zu bestimmen.

5. Batteriemanagementvorrichtung nach Anspruch 4, wobei die Steuerung (230) ferner dazu konfiguriert ist, die mindestens eine zweite Batterie (20) benachbart zu der ersten Batterie (10) basierend auf einer Anordnungsreihenfolge der Vielzahl von Batterien (10, 20, 30, 40, 50) zu bestimmen, wenn eine anormale Temperatur oder ein Anomaliesignal der ersten Batterie (10) aus der Vielzahl von Batterien (10, 20, 30, 40, 50) erfasst wird.

6. Batteriemanagementvorrichtung nach Anspruch 4, wobei die Steuerung (230) ferner dazu konfiguriert ist, eine Kapazität der ersten Batterie (10) und eine Kapazität der mindestens einen zweiten Batterie (20) zu berechnen und die Kapazität der ersten Batterie (10) mit der Kapazität der zweiten Batterie zu vergleichen, um die Operationen der Vielzahl von ersten Schaltern (210) und der Vielzahl von zweiten Schaltern (220) zu steuern.

7. Batteriemanagementvorrichtung nach Anspruch 6, wobei, wenn die Kapazität der ersten Batterie (10) die Kapazität der mindestens einen zweiten Batterie (20) übersteigt, die Steuerung (230) ferner dazu konfiguriert ist, einen ersten Schalter zum Schalten der ersten Batterie (10) mit einem mit der ersten Batterie (10) geschalteten Widerstand aus der Vielzahl von ersten Schaltern (210) einzuschalten und mindestens einen beliebigen zweiten Schalter aus der Vielzahl von zweiten Schaltern (220) einzuschalten.

8. Batteriemanagementvorrichtung nach Anspruch 6, wobei, wenn die Kapazität der ersten Batterie (10) geringer ist als die Kapazität der mindestens einen zweiten Batterie (20), die Steuerung (230) ferner dazu konfiguriert ist, einen ersten Schalter zum Schalten der zweiten Batterie mit einem mit der zweiten Batterie geschalteten Widerstand aus der Vielzahl von ersten Schaltern (210) einzuschalten und mindestens einen beliebigen zweiten Schalter aus der Vielzahl von zweiten Schaltern (220) einzuschalten.

9. Betriebsverfahren einer Batteriemanagementvorrichtung, wobei das Betriebsverfahren umfasst:
Bestimmen, ob mindestens eine der Vielzahl von Batterien (10, 20, 30, 40, 50) anormal ist;
Steuern von Operationen einer Vielzahl von ersten Schaltern (210) zum jeweiligen Schalten einer Vielzahl von Widerständen (R), die jeweils mit der Vielzahl von Batterien (10, 20, 30, 40, 50) geschaltet sind, mit Batteriestromausgangsanschlüssen der Vielzahl von Batterien (10, 20, 30, 40, 50), basierend darauf, ob mindestens eine der Vielzahl von Batterien (10, 20, 30, 40, 50) anormal ist; und
Steuern von Operationen einer Vielzahl von zweiten Schaltern (220), welche die Vielzahl von Widerständen (R) parallel schalten, um mindestens einen Teil der Vielzahl von Batterien über die parallel geschalteten Widerstände zu entladen,
wobei jeder der Vielzahl von ersten Schaltern mit einem entsprechenden Widerstand an einem ersten Knoten geschaltet ist, und
wobei jeder der Vielzahl von zweiten Schaltern zwischen zwei benachbarten ersten Knoten von zwei benachbarten ersten Schaltern in der Vielzahl von ersten Schaltern geschaltet ist.

10. Betriebsverfahren nach Anspruch 9, wobei das Bestimmen, ob jede der Vielzahl von Batterien (10, 20, 30, 40, 50) anormal ist, Folgendes umfasst:
Empfangen eines Anomaliesignals der Vielzahl von Batterien (10, 20, 30, 40, 50) von einem Batteriemanagementsystem (BMS) für jede der Vielzahl von Batterien (10, 20, 30, 40, 50); und
Bestimmen einer ersten Batterie (10), für die ein Anomaliesignal erfasst wird, und mindestens einer zweiten Batterie (20), die sich auf die erste Batterie (10) bezieht, aus der Vielzahl von Batterien (10, 20, 30, 40, 50), basierend auf dem Anomaliesignal.

11. Betriebsverfahren nach Anspruch 10, wobei das Bestimmen, ob jede der Vielzahl von Batterien (10, 20, 30, 40, 50) anormal ist, Folgendes umfasst:
Erhalten von Temperaturinformationen der Vielzahl von Batterien (10, 20, 30, 40, 50) von einer Vielzahl von Temperaturmesssensoren (T1, T2, T3, T4, T5), die Temperaturen der Vielzahl von Batterien (10, 20, 30, 40, 50) messen; und
Bestimmen einer ersten Batterie (10), für die eine anormale Temperatur erfasst wird, und mindestens einer zweiten Batterie (20), die sich auf die erste Batterie (10) bezieht, aus der Vielzahl von Batterien (10, 20, 30, 40, 50), basierend auf den Temperaturinformationen.

12. Betriebsverfahren nach Anspruch 11, wobei das Bestimmen, ob jede der Vielzahl von Batterien (10, 20, 30, 40, 50) anormal ist, das Bestimmen der mindestens einen zweiten Batterie (20) benachbart zu der ersten Batterie (10) basierend auf einer Anordnungsreihenfolge der Vielzahl von Batterien (10, 20, 30, 40, 50) umfasst, wenn eine anormale Temperatur oder ein Anomaliesignal der ersten Batterie (10) aus der Vielzahl von Batterien (10, 20, 30, 40, 50) erfasst wird.

13. Betriebsverfahren nach Anspruch 12, wobei das Bestimmen, ob jede der Vielzahl von Batterien (10, 20, 30, 40, 50) anormal ist, das Berechnen einer Kapazität der ersten Batterie (10) und einer Kapazität der mindestens einen zweiten Batterie (20) und das Vergleichen der Kapazität der ersten Batterie (10) mit der Kapazität der zweiten Batterie umfasst, um die Operationen der Vielzahl von ersten Schaltern (210) und der Vielzahl von zweiten Schaltern (220) zu steuern.

14. Betriebsverfahren nach Anspruch 13, wobei das Steuern der Operationen einer Vielzahl von ersten Schaltern (210) zum jeweiligen Schalten einer Vielzahl von Widerständen (R), die jeweils mit der Vielzahl von Batterien (10, 20, 30, 40, 50) geschaltet sind, mit Batteriestromausgangsanschlüssen der Vielzahl von Batterien (10, 20, 30, 40, 50), basierend darauf, ob jede der Vielzahl von Batterien (10, 20, 30, 40, 50) anormal ist, umfasst, wenn die Kapazität der ersten Batterie (10) die Kapazität der mindestens einen zweiten Batterie (20) übersteigt, das Einschalten eines ersten Schalters zum Schalten der ersten Batterie (10) mit einem mit der ersten Batterie (10) geschalteten Widerstand aus der Vielzahl von ersten Schaltern (210), und
das Steuern der Operationen einer Vielzahl von zweiten Schaltern (220), welche die Vielzahl von Widerständen (R) parallel schalten, das Einschalten mindestens eines beliebigen zweiten Schalters aus der Vielzahl von zweiten Schaltern (220) umfasst.

15. Betriebsverfahren nach Anspruch 13, wobei das Steuern der Operationen einer Vielzahl von ersten Schaltern (210) zum jeweiligen Schalten einer Vielzahl von Widerständen (R), die jeweils mit der Vielzahl von Batterien (10, 20, 30, 40, 50) geschaltet sind, mit Batteriestromausgangsanschlüssen der Vielzahl von Batterien (10, 20, 30, 40, 50), basierend darauf, ob jede der Vielzahl von Batterien (10, 20, 30, 40, 50) anormal ist, umfasst, wenn die Kapazität der ersten Batterie (10) geringer ist als die Kapazität der mindestens einen zweiten Batterie (20), das Einschalten eines ersten Schalters zum Schalten der zweiten Batterie mit einem mit der zweiten Batterie geschalteten Widerstand aus der Vielzahl von ersten Schaltern (210), und
das Steuern der Operationen einer Vielzahl von zweiten Schaltern (220), welche die Vielzahl von Widerständen (R) parallel schalten, das Einschalten mindestens eines beliebigen zweiten Schalters aus der Vielzahl von zweiten Schaltern (220) umfasst.

## Revendications

1. Appareil de gestion de batterie comprenant :
une pluralité de résistances (R) connectées respectivement à une pluralité de batteries (10, 20, 30, 40, 50) ;
une pluralité de premiers interrupteurs (210) configurés pour connecter respectivement la pluralité de résistances (R) à des bornes de sortie de la pluralité de batteries (10, 20, 30, 40, 50), dans lequel chacun de la pluralité de premiers interrupteurs est connecté à une résistance correspondante au niveau d'un premier nœud ;
une pluralité de seconds interrupteurs (220) configurés pour connecter la pluralité de résistances (R) en parallèle, dans lequel chacun de la pluralité de seconds interrupteurs est connecté entre deux premiers nœuds adjacents de deux premiers interrupteurs adjacents dans la pluralité de premiers interrupteurs ; et
un contrôleur (230) configuré pour déterminer si au moins une de la pluralité de batteries (10, 20, 30, 40, 50) est anormale, et commander des opérations de la pluralité de premiers interrupteurs (210) et de la pluralité de seconds interrupteurs (220) pour décharger au moins une partie de la pluralité de batteries via les résistances connectées en parallèle sur la base du fait qu'au moins une de la pluralité de batteries (10, 20, 30, 40, 50) est anormale.

2. L'appareil de gestion de batterie selon la revendication 1, dans lequel la pluralité de résistances (R) sont respectivement connectées à la pluralité de batteries (10, 20, 30, 40, 50) en série, et
la pluralité de seconds interrupteurs (220) sont connectés en série les uns aux autres.

3. L'appareil de gestion de batterie selon la revendication 2, comprenant en outre une unité de communication (240) configurée pour recevoir un signal d'anomalie de la pluralité de batteries (10, 20, 30, 40, 50) depuis un système de gestion de batterie (BMS) pour chacune de la pluralité de batteries (10, 20, 30, 40, 50),
dans lequel le contrôleur (230) est en outre configuré pour déterminer une première batterie (10) pour laquelle un signal d'anomalie est détecté et au moins une seconde batterie (20) liée à la première batterie (10) parmi la pluralité de batteries (10, 20, 30, 40, 50), sur la base du signal d'anomalie.

4. L'appareil de gestion de batterie selon la revendication 3, dans lequel le contrôleur (230) est en outre configuré pour obtenir des informations de température de la pluralité de batteries (10, 20, 30, 40, 50) depuis une pluralité de capteurs de mesure de température (T1, T2, T3, T4, T5) qui mesurent les températures de la pluralité de batteries (10, 20, 30, 40, 50), et déterminer une première batterie (10) pour laquelle une température anormale est détectée et au moins une seconde batterie (20) liée à la première batterie (10) parmi la pluralité de batteries (10, 20, 30, 40, 50), sur la base des informations de température.

5. L'appareil de gestion de batterie selon la revendication 4, dans lequel le contrôleur (230) est en outre configuré pour déterminer l'au moins une seconde batterie (20) adjacente à la première batterie (10) sur la base d'un ordre d'agencement de la pluralité de batteries (10, 20, 30, 40, 50), lors de la détection d'une température anormale ou d'un signal d'anomalie de la première batterie (10) parmi la pluralité de batteries (10, 20, 30, 40, 50).

6. L'appareil de gestion de batterie selon la revendication 4, dans lequel le contrôleur (230) est en outre configuré pour calculer une capacité de la première batterie (10) et une capacité de l'au moins une seconde batterie (20) et comparer la capacité de la première batterie (10) avec la capacité de la seconde batterie pour commander les opérations de la pluralité de premiers interrupteurs (210) et de la pluralité de seconds interrupteurs (220).

7. L'appareil de gestion de batterie selon la revendication 6, dans lequel, lorsque la capacité de la première batterie (10) dépasse la capacité de l'au moins une seconde batterie (20), le contrôleur (230) est en outre configuré pour activer un premier interrupteur pour connecter la première batterie (10) à une résistance connectée à la première batterie (10) parmi la pluralité de premiers interrupteurs (210) et activer au moins un second interrupteur quelconque parmi la pluralité de seconds interrupteurs (220).

8. L'appareil de gestion de batterie selon la revendication 6, dans lequel, lorsque la capacité de la première batterie (10) est inférieure à la capacité de l'au moins une seconde batterie (20), le contrôleur (230) est en outre configuré pour activer un premier interrupteur pour connecter la seconde batterie à une résistance connectée à la seconde batterie parmi la pluralité de premiers interrupteurs (210) et activer au moins un second interrupteur quelconque parmi la pluralité de seconds interrupteurs (220).

9. Procédé de fonctionnement d'un appareil de gestion de batterie, le procédé de fonctionnement comprenant :
la détermination du fait qu'au moins une de la pluralité de batteries (10, 20, 30, 40, 50) est anormale ;
la commande d'opérations d'une pluralité de premiers interrupteurs (210) pour connecter respectivement une pluralité de résistances (R) respectivement connectées à la pluralité de batteries (10, 20, 30, 40, 50) à des bornes de sortie de courant de batterie de la pluralité de batteries (10, 20, 30, 40, 50), sur la base du fait qu'au moins une de la pluralité de batteries (10, 20, 30, 40, 50) est anormale ; et
la commande d'opérations d'une pluralité de seconds interrupteurs (220) connectant la pluralité de résistances (R) en parallèle pour décharger au moins une partie de la pluralité de batteries via les résistances connectées en parallèle,
dans lequel chacun de la pluralité de premiers interrupteurs est connecté à une résistance correspondante au niveau d'un premier nœud, et
dans lequel chacun de la pluralité de seconds interrupteurs est connecté entre deux premiers nœuds adjacents de deux premiers interrupteurs adjacents dans la pluralité de premiers interrupteurs.

10. Le procédé de fonctionnement selon la revendication 9, dans lequel la détermination du fait que chacune de la pluralité de batteries (10, 20, 30, 40, 50) est anormale comprend :
la réception d'un signal d'anomalie de la pluralité de batteries (10, 20, 30, 40, 50) depuis un système de gestion de batterie (BMS) pour chacune de la pluralité de batteries (10, 20, 30, 40, 50) ; et
la détermination d'une première batterie (10) pour laquelle un signal d'anomalie est détecté et d'au moins une seconde batterie (20) liée à la première batterie (10) parmi la pluralité de batteries (10, 20, 30, 40, 50), sur la base du signal d'anomalie.

11. Le procédé de fonctionnement selon la revendication 10, dans lequel la détermination du fait que chacune de la pluralité de batteries (10, 20, 30, 40, 50) est anormale comprend :
l'obtention d'informations de température de la pluralité de batteries (10, 20, 30, 40, 50) depuis une pluralité de capteurs de mesure de température (T1, T2, T3, T4, T5) qui mesurent les températures de la pluralité de batteries (10, 20, 30, 40, 50) ; et
la détermination d'une première batterie (10) pour laquelle une température anormale est détectée et d'au moins une seconde batterie (20) liée à la première batterie (10) parmi la pluralité de batteries (10, 20, 30, 40, 50), sur la base des informations de température.

12. Le procédé de fonctionnement selon la revendication 11, dans lequel la détermination du fait que chacune de la pluralité de batteries (10, 20, 30, 40, 50) est anormale comprend la détermination de l'au moins une seconde batterie (20) adjacente à la première batterie (10) sur la base d'un ordre d'agencement de la pluralité de batteries (10, 20, 30, 40, 50), lors de la détection d'une température anormale ou d'un signal d'anomalie de la première batterie (10) parmi la pluralité de batteries (10, 20, 30, 40, 50).

13. Le procédé de fonctionnement selon la revendication 12, dans lequel la détermination du fait que chacune de la pluralité de batteries (10, 20, 30, 40, 50) est anormale comprend le calcul d'une capacité de la première batterie (10) et d'une capacité de l'au moins une seconde batterie (20) et la comparaison de la capacité de la première batterie (10) avec la capacité de la seconde batterie pour commander les opérations de la pluralité de premiers interrupteurs (210) et de la pluralité de seconds interrupteurs (220).

14. Le procédé de fonctionnement selon la revendication 13, dans lequel la commande des opérations d'une pluralité de premiers interrupteurs (210) pour connecter respectivement une pluralité de résistances (R) respectivement connectées à la pluralité de batteries (10, 20, 30, 40, 50) à des bornes de sortie de courant de batterie de la pluralité de batteries (10, 20, 30, 40, 50), sur la base du fait que chacune de la pluralité de batteries (10, 20, 30, 40, 50) est anormale, comprend, lorsque la capacité de la première batterie (10) dépasse la capacité de l'au moins une seconde batterie (20), l'activation d'un premier interrupteur pour connecter la première batterie (10) à une résistance connectée à la première batterie (10) parmi la pluralité de premiers interrupteurs (210), et
la commande des opérations d'une pluralité de seconds interrupteurs (220) connectant la pluralité de résistances (R) en parallèle comprend l'activation d'au moins un second interrupteur quelconque parmi la pluralité de seconds interrupteurs (220).

15. Le procédé de fonctionnement selon la revendication 13, dans lequel la commande des opérations d'une pluralité de premiers interrupteurs (210) pour connecter respectivement une pluralité de résistances (R) respectivement connectées à la pluralité de batteries (10, 20, 30, 40, 50) à des bornes de sortie de courant de batterie de la pluralité de batteries (10, 20, 30, 40, 50), sur la base du fait que chacune de la pluralité de batteries (10, 20, 30, 40, 50) est anormale, comprend, lorsque la capacité de la première batterie (10) est inférieure à la capacité de l'au moins une seconde batterie (20), l'activation d'un premier interrupteur pour connecter la seconde batterie à une résistance connectée à la seconde batterie parmi la pluralité de premiers interrupteurs (210), et
la commande des opérations d'une pluralité de seconds interrupteurs (220) connectant la pluralité de résistances (R) en parallèle comprend l'activation d'au moins un second interrupteur quelconque parmi la pluralité de seconds interrupteurs (220).
